# EUROPÄISCHE PATENTSCHRIFT

(11) **EP 1 771 319 B1**
(45) Veröffentlichungstag und Bekanntmachung des Hinweises auf die Patenterteilung: **06.10.2010**
(21) Anmeldenummer: 05771999.9
(22) Anmeldetag: 26.07.2005
(51) Int. Cl.: B60R 16/02, H02J 7/00

(54) **VORRICHTUNG ZUR VERSORGUNG EINER KRAFTSTOFFPUMPE EINER BRENNKRAFTMASCHINE EINES KRAFTFAHRZEUGES MIT ELEKTRISCHEM STROM**
DEVICE FOR SUPPLYING ELECTRIC CURRENT TO THE FUEL PUMP OF A MOTOR VEHICLE INTERNAL COMBUSTION ENGINE
SYSTEME POUR ALIMENTER UNE POMPE A CARBURANT D'UN MOTEUR A COMBUSTION D'UN VEHICULE AUTOMOBILE EN COURANT ELECTRIQUE

(30) Priorität: 29.07.2004 DE 102004036814
(43) Veröffentlichungstag der Anmeldung: 11.04.2007
(73) Patentinhaber: Continental Automotive GmbH, 30165 Hannover (DE)
(72) Erfinder: RUMPF, Bernd, 61130 Nidderau-Windecken (DE)
(86) Internationale Anmeldenummer: PCT/EP2005/053639
(87) Internationale Veröffentlichungsnummer: WO 2006/013175

(56) Entgegenhaltungen:
- EP-A- 0 081 593
- US-A- 5 982 604
- PATENT ABSTRACTS OF JAPAN Bd. 014, Nr. 216 (E-0924), 8. Mai 1990 (1990-05-08) & JP 02 051334 A (KUBOTA LTD), 21. Februar 1990 (1990-02-21)

## Beschreibung

Die Erfindung betrifft eine Vorrichtung zur Versorgung einer Kraftstoffpumpe einer Brennkraftmaschine eines Kraftfahrzeuges mit elektrischem Strom, mit einem mit einer Gleichspannungsquelle zu verbindenden ersten Anschluss und mit einem mit der Kraftstoffpumpe zu verbindenden zweiten Anschluss.

Solche Vorrichtungen verbinden bei einem Start der Brennkraftmaschine die Kraftstoffpumpe mit der Gleichspannungsquelle. Die Gleichspannungsquelle ist bei heutigen Kraftfahrzeugen ein Akkumulator, welcher während des Betriebs der Brennkraftmaschine aufgeladen wird. Die Kraftstoffpumpe ist dabei für die Spannung der Gleichspannungsquelle von beispielsweise 12 Volt ausgelegt und versorgt die Brennkraftmaschine mit Kraftstoff. Nach dem Start erfolgt die Versorgung der Kraftstoffpumpe in der Regel über einen von der Brennkraftmaschine angetriebenen Generator mit einer im Wesentlichen konstanten Spannung. Die Spannung der Gleichspannungsquelle ist jedoch abhängig von der Temperatur, deren Alter, Wartungszustand und weiteren Faktoren. Insbesondere bei niedrigen Temperaturen sinkt die Spannung der Gleichspannungsquelle sehr stark, beispielsweise auf 7 Volt ab. Daher ist bei niedrigen Temperaturen eine zuverlässige Versorgung der Brennkraftmaschine mit Kraftstoff nicht mehr zuverlässig gewährleistet. Heutige Motormanagementsysteme benötigen zur Erfüllung der Abgasnormen schon beim Starten der Brennkraftmaschine definierte Drücke und Förderleistungen der Kraftstoffpumpe

Man könnte daran denken, mehrere, für unterschiedliche Spannungen ausgelegte Kraftstoffpumpen vorzusehen und bei einer Spannung der Gleichspannungsquelle von 7 Volt eine für 7 Volt ausgelegte Kraftstoffpumpe anzusteuern. Bei einer Spannung von 12 Volt wird dann auf eine für 12 Volt ausgelegte Brennkraftmaschine umgeschaltet. Dies erfordert jedoch einen sehr hohen baulichen Aufwand und ist daher sehr kostenintensiv.

Aus der EP 0 081 593 ist eine Energieversorgung für den Speicher eines Mikrocomputers bekannt, bei der zu einem DC-DC-Wandler eine Diode parallel geschalten ist. Über einen weiteren circuit wird die Spannung letztendlich dem Mikrocomputer zugeführt. Nachteilig bei dieser Anordnung ist der erhebliche Aufwand, der zum Betreiben eines Mikrocomputers erforderlich ist.

Der Erfindung liegt das Problem zugrunde, eine Vorrichtung der eingangs genannten Art so zu gestalten, dass die Kraftstoffpumpe auch bei niedrigen Temperaturen und kleinen Spannungen eine zuverlässige Versorgung der Brennkraftmaschine mit Kraftstoff ermöglicht.

Dieses Problem wird erfindungsgemäß durch den Gegenstand des Anspruchs 1 gelöst.

Durch diese Gestaltung wird eine zu niedrige Spannung der Gleichspannungsquelle von dem DC/DC Wandler angehoben. Daher wird auch bei zu niedriger Spannung der Gleichspannungsquelle sichergestellt, dass eine ausreichende Spannung an dem zu der Kraftstoffpumpe führenden zweiten Anschluss anliegt. Damit wird auch bei sehr niedrigen Temperaturen die Brennkraftmaschine zuverlässig mit Kraftstoff versorgt. Da die Versorgung der Brennkraftmaschine mittels einer einzigen, auf eine einzige vorgesehene Spannung ausgelegten Kraftstoffpumpe erfolgen kann, führt die erfindungsgemäße Vorrichtung zu einer besonders kostengünstigen Versorgung der Brennkraftmaschine mit Kraftstoff.

Bei ausreichender Spannung der Gleichspannungsquelle lässt sich ein unnötiger Betrieb des DC/DC Wandlers einfach vermeiden, wenn der DC/DC Wandler parallel mit einer Überbrückung, welche die beiden Anschlüsse unmittelbar miteinander verbindet, geschaltet ist und wenn ein Wechselschalter zur wahlweisen Ansteuerung des DC/DC Wandlers oder der Überbrückung vorgesehen ist.

Eine zu niedrige Spannung der Gleichspannungsquelle lässt sich gemäß einer vorteilhaften Weiterbildung der Erfindung einfach erfassen, wenn eine Überwachungseinrichtung zur Überwachung der Spannung der Gleichspannungsquelle mit dem ersten Anschluss verbunden ist. Damit lässt sich anhand von Werten der Überwachungseinrichtung einfach entscheiden, ob der DC/DC Wandler angesteuert werden muss.

Eine besonders zuverlässige Erfassung der Spannung der Gleichspannungsquelle lässt sich gemäß einer anderen vorteilhaften Weiterbildung der Erfindung einfach sicherstellen, wenn die Überwachungseinrichtung einen Spannungsdetektor mit einer Watch-Dog-Schaltung zur Überwachung der Funktion des Spannungsdetektors aufweist.

Die erfindungsgemäße Vorrichtung gestaltet sich konstruktiv besonders einfach, wenn der Wechselschalter an dem ersten Anschluss angeordnet und mit der Überbrückung und dem DC/DC Wandler verbunden ist.

Ein manueller Eingriff in die erfindungsgemäße Vorrichtung lässt sich gemäß einer anderen vorteilhaften Weiterbildung der Erfindung einfach vermeiden, wenn der Wechselschalter von der Überwachungseinrichtung ansteuerbar ist.

Die Ansteuerung des Wechselschalters in Abhängigkeit von der Spannung der Gleichspannungsquelle erfordert gemäß einer anderen vorteilhaften Weiterbildung der Erfindung einen besonders geringen baulichen Aufwand, wenn die Ansteuerung des Wechselschalters mittels der Überwachungseinrichtung eine Transistorschaltung oder ein Relais aufweist.

Zur weiteren Vereinfachung der Ansteuerung des Wechselschalters trägt es gemäß einer anderen vorteilhaften Weiterbildung der Erfindung bei, wenn die Überwachungseinrichtung einen Signalgeber zur Erzeugung eines elektrischen Signals aufweist und wenn das elektrische Signal oberhalb einer vorgesehenen Spannung der Gleichspannungsquelle unterbleibt. Damit erhält der Wechselschalter ein eindeutiges Signal, bei dessen Vorhandensein der DC/DC Wandler mittels des Wechselschalters aktiviert oder nicht aktiviert wird.

Bei einem Defekt der Überwachungseinrichtung lässt sich ein unnötiger Betrieb des DC/DC Wandlers gemäß einer anderen vorteilhaften Weiterbildung der Erfindung einfach vermeiden, wenn in Ruhestellung der Wechselschalter zur Ansteuerung der Überbrückung gestaltet ist. Durch die Vermeidung des unnötigen Betriebs des DC/DC Wandlers wird zudem eine erforderliche Kühlleistung des DC/DC Wandlers besonders gering gehalten.

In der Regel steht nach dem Start der Brennkraftmaschine des Kraftfahrzeuges eine ausreichende Spannung zur Versorgung der Kraftstoffpumpe zur Verfügung. In diesem Fall ist der Betrieb des DC/DC Wandlers nicht mehr erforderlich und sollte zur Vermeidung von Beschädigungen der Kraftstoffpumpe unterbleiben. Der DC/DC Wandler lässt sich gemäß einer anderen vorteilhaften Weiterbildung der Erfindung nach dem Start der Brennkraftmaschine einfach deaktivieren, wenn die Überwachungseinrichtung eine Zeitschaltung hat, und wenn oberhalb einer vorgesehenen Zeitspanne nach der Aktivierung des DC/DC Wandlers die Zeitschaltung die Überbrückung aktiviert. Die Zeitschaltung stellt damit sicher, dass unabhängig von der von der Überwachungseinrichtung ermittelten Spannung der DC/DC Wandler nach Ablauf der Zeitspanne deaktiviert und die beiden Anschlüsse über die Überbrückung miteinander verbunden werden. Vorzugsweise erfolgt die Deaktivierung des DC/DC Wandlers und die Aktivierung der Überbrückung über den Wechselschalter.

Eine bis zum Start der Brennkraftmaschine notwendige Aktivierung des DC/DC Wandlers lässt sich gemäß einer anderen vorteilhaften Weiterbildung der Erfindung einfach sicherstellen, wenn die vorgesehene Zeitspanne der Zeitschaltung 20 bis 180 Sekunden beträgt. Wenn nach Ablauf der Zeitspanne die Brennkraftmaschine nicht startet und damit auch keine ausreichende Spannung für die Kraftstoffpumpe liefert, ist dies ein Hinweis darauf, dass ein Defekt an der Brennkraftmaschine vorliegt. Die Zeitspanne von 20 bis 180 Sekunden der Zeitschaltung stellt sicher, dass bei einem solchen Defekt eine Beschädigung des DC/DC Wandlers verhindert wird. Vorzugsweise beträgt die Zeitspanne 60 Sekunden. Die Zeitschaltung überlagert alle anderen Programme der Vorrichtung. Nach Ablauf der Zeitspanne wird die Kraftstoffpumpe unmittelbar aus der Gleichspannungsquelle mit elektrischem Strom versorgt.

Die Erfindung lässt zahlreiche Ausführungsformen zu. Zur weiteren Verdeutlichung ihres Grundprinzips ist eine davon in der Zeichnung dargestellt und wird nachfolgend beschrieben. Diese zeigt in
- Fig. 1: einen Schaltplan der erfindungsgemäßen Vorrichtung bei ausreichender Spannung einer Gleichspannungs- quelle,
- Fig. 2: den Schaltplan aus Figur 1 bei zu geringer Spannung der Gleichspannungsquelle.

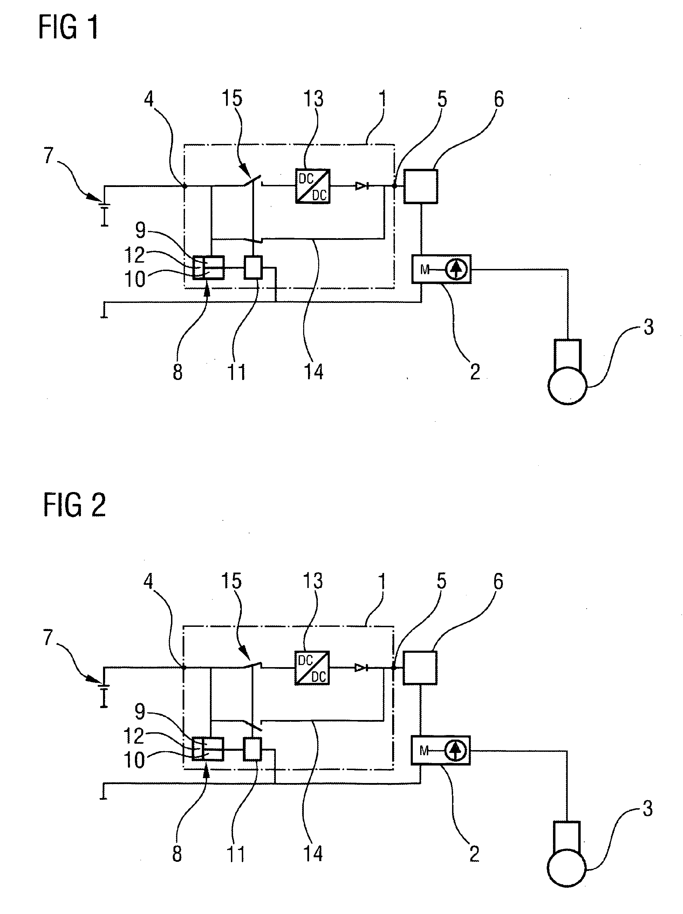

Die Figuren 1 und 2 zeigen eine Vorrichtung 1 zur Versorgung einer Kraftstoffpumpe 2 einer Brennkraftmaschine 3 eines Kraftfahrzeuges mit elektrischem Strom. Die Vorrichtung 1 weist einen ersten, mit einer Gleichspannungsquelle verbundenen Anschluss 4 und einen zweiten, mit einer Bedarfssteuerung 6 der Kraftstoffpumpe 2 verbundenen Anschluss 5 auf. Die Bedarfssteuerung 6 ist optional und kann in einer alternativen Ausführungsform entfallen. Die Bedarfssteuerung 6 verbindet den zweiten Anschluss 5 der Vorrichtung 1 mit der Kraftstoffpumpe 2, wenn die Brennkraftmaschine 3 gestartet werden soll und während des Betriebs der Brennkraftmaschine 3. Der erste Anschluss 4 der Vorrichtung 1 ist mit einer als Kraftfahrzeugbatterie ausgebildeten Gleichspannungsquelle 7 verbunden. Eine Grenzspannung der Gleichspannungsquelle 7 wird von einer Überwachungseinrichtung 8 überwacht. Die Überwachungseinrichtung 8 weist einen mit dem ersten Anschluss 4 verbundenen Spannungsdetektor 9 und eine Watch-Dog-Schaltung 10 auf und ist mit einem Relais 11 verbunden. Weiterhin ist die Überwachungseinrichtung 8 mit einer Zeitschaltung 12 verbunden.

Die Vorrichtung 1 weist einen DC/DC Wandler 13 auf, welcher eine niedrige Gleichspannung unterhalb der Grenzspannung von beispielsweise acht bis neun Volt an dem ersten Anschluss 4 in eine vorgesehene größere Betriebsspannung von beispielsweise zwölf Volt an dem zweiten Anschluss 5 umwandelt. Der DC/DC Wandler 13 ist parallel mit einer Überbrückung 14 geschaltet, welche die beiden Anschlüsse 4, 5 der Vorrichtung 1 unmittelbar miteinander verbindet. Ein Wechselschalter 15 verbindet wahlweise die Überbrückung 14 oder den DC/DC Wandler 13 mit dem ersten Anschluss 4. Der Wechselschalter 15 wird von dem Relais 11 geschaltet.

Wenn die Spannung der Gleichspannungsquelle 7 unterhalb der Grenzspannung absinkt, wird die Spannung von der Überwachungseinrichtung 8 erfasst und das Relais 11 angesteuert, so dass der DC/DC Wandler 13 die beiden Anschlüsse 4, 5 der Vorrichtung 1 verbindet. Die Verbindung der Überbrückung 14 mit dem ersten Anschluss 4 wird dabei von dem Wechselschalter 15 unterbrochen, so dass ausschließlich die Kraftstoffpumpe 2 über den DC/DC Wandler 13 mit elektrischen Strom versorgt wird. Da der DC/DC Wandler 13 die Gleichspannung von unterhalb der Grenzspannung, z. B. sieben Volt auf die Betriebsspannung, z. B. zwölf Volt erhöht, wird die Kraftstoffpumpe 2 mit elektrischen Strom einer Spannung von zwölf Volt versorgt. Dies ermöglicht eine ausreichende Förderleistung der Kraftstoffpumpe 2, so dass die Brennkraftmaschine 3 mit der ausreichenden Menge an Kraftstoff versorgt wird. Diese Stellung des Wechselschalters 15 ist in Figur 2 dargestellt.

Wird von der Überwachungseinrichtung 8 eine Spannung oberhalb der Grenzspannung erfasst, unterbleibt die Ansteuerung des Relais 11, wodurch die Anschlüsse 4, 5 der Vorrichtung 1 über die Überbrückung 14 miteinander verbunden sind. Dies ist die Grundstellung der Vorrichtung 1, welche in Figur 1 dargestellt ist. Ebenfalls unterbleibt bei einem Defekt des Spannungsdetektors 9 oder nach einer vorgesehenen, in der Zeitschaltung 12 einprogrammierten Zeitspanne nach dem Start der Kraftstoffpumpe 2 die Ansteuerung des Relais 11, so dass auch in diesen Fällen die Versorgung der Kraftstoffpumpe 2 über die Überbrückung 14 erfolgt.

Anstelle des Relais 11 und des mechanisch dargestellten Wechselschalters 15 kann auch eine Transistorschaltung vorgesehen sein, welche wahlweise den DC/DC Wandler 13 oder die Überbrückung 14 mit dem ersten Anschluss 4 verbindet.

## Patentansprüche

1. Vorrichtung zur Versorgung einer Kraftstoffpumpe einer Brennkraftmaschine eines Kraftfahrzeuges mit elektrischem Strom, mit einem mit einer Gleichspannungsquelle zu verbindenden ersten Anschluss und mit einem mit der Kraftstoffpumpe zu verbindenden zweiten Anschluss, **dadurch gekennzeichnet, dass** zwischen den Anschlüssen (4, 5) ein DC/DC Wandler (13), welcher zur Erhöhung der Gleichspannung der Gleichspannungsquelle (7) von einer niedrigen Gleichspannung unterhalb der Grenzspannung an dem ersten Anschluss (4) in eine vorgesehene größere Betriebsspannung an dem zweiten Anschluss (5) ausgebildet ist, angeordnet ist, dass der DC/DC Wandler (13) parallel mit einer Überbrückung (14), welche die beiden Anschlüsse (4, 5) bei ausreichender Spannung der Gleichspanngsquelle unmittelbar miteinander verbindet, geschaltet ist und dass ein Wechselschalter (15) zur wahlweisen Ansteuerung des DC/DC Wandlers (13) oder der Überbrückung (14) vorgesehen ist.

2. Vorrichtung nach Anspruch 1, **dadurch gekennzeichnet, dass** eine Überwachungseinrichtung (8) zur Überwachung der Spannung der Gleichspannungsquelle (7) mit dem ersten Anschluss (4) verbunden ist.

3. Vorrichtung nach Anspruch 1 oder 2, **dadurch gekennzeichnet, dass** die Überwachungseinrichtung (8) einen Spannungsdetektor (9) mit einer Watch-Dog-Schaltung (10) zur Überwachung der Funktion des Spannungsdetektors (9) aufweist.

4. Vorrichtung nach zumindest einem der vorhergehenden Ansprüche, **dadurch gekennzeichnet, dass** der Wechselschalter (15) an dem ersten Anschluss (4) angeordnet und mit der Überbrückung (14) und dem DC/DC Wandler (13) verbunden ist.

5. Vorrichtung nach zumindest einem der vorhergehenden Ansprüche, **dadurch gekennzeichnet, dass** der Wechselschalter (15) von der Überwachungseinrichtung (8) ansteuerbar ist.

6. Vorrichtung nach zumindest einem der vorhergehenden Ansprüche, **dadurch gekennzeichnet, dass** die Ansteuerung des Wechselschalters (15) mittels der Überwachungseinrichtung (8) eine Transistorschaltung oder ein Relais (11) aufweist.

7. Vorrichtung nach zumindest einem der vorhergehenden Ansprüche, **dadurch gekennzeichnet, dass** die Überwachungseinrichtung (8) einen Signalgeber zur Erzeugung eines elektrischen Signals aufweist und dass das elektrische Signal oberhalb einer vorgesehenen Spannung der Gleichspannungsquelle (7) unterbleibt.

8. Vorrichtung nach zumindest einem der vorhergehenden Ansprüche, **dadurch gekennzeichnet, dass** in Ruhestellung der Wechselschalter (15) zur Ansteuerung der Überbrückung (14) gestaltet ist.

9. Vorrichtung nach zumindest einem der vorhergehenden Ansprüche, **dadurch gekennzeichnet, dass** die Überwachungseinrichtung (8) eine Zeitschaltung (12) hat, und dass oberhalb einer vorgesehenen Zeitspanne nach der Aktivierung des DC/DC Wandlers (13) die Zeitschaltung (12) die Überbrückung (14) aktiviert.

10. Vorrichtung nach zumindest einem der vorhergehenden Ansprüche, **dadurch gekennzeichnet, dass** die vorgesehene Zeitspanne der Zeitschaltung (12) 20 bis 180 Sekunden beträgt.

## Claims

1. Device for supplying electrical power to a fuel pump of a motor vehicle internal combustion engine, having a first terminal to be connected to a DC voltage source, and having a second terminal to be connected to the fuel pump, **characterized in that** a DC/DC converter (13) designed to increase the DC voltage from the DC voltage source (7) from a low DC voltage below the threshold voltage at the first terminal (4) into a designated larger operating voltage at the second terminal (5) is arranged between the terminals (4, 5), that the DC/DC converter (13) is connected in parallel with a bypass link (14) connecting the two terminals (4, 5) directly together when there is sufficient voltage in the DC voltage source, and that a changeover switch (15) is provided for selective activation of the DC/DC converter (13) or the bypass link (14).

2. Device according to Claim 1, **characterized in that** a monitoring device (8) for monitoring the voltage from the DC voltage source (7) is connected to the first terminal (4).

3. Device according to Claim 1 or 2, **characterized in that** the monitoring device (8) comprises a voltage detector (9) having a watchdog circuit (10) for checking that the voltage detector (9) is working.

4. Device according to at least one of the previous claims, **characterized in that** the changeover switch (15) is arranged at the first terminal (4) and connected to the bypass link (14) and the DC/DC converter (13).

5. Device according to at least one of the previous claims, **characterized in that** the changeover switch (15) can be controlled by the monitoring device (8).

6. Device according to at least one of the previous claims, **characterized in that** control of the changeover switch (15) by means of the monitoring device (8) comprises a transistor circuit or a relay (11).

7. Device according to at least one of the previous claims, **characterized in that** the monitoring device (8) comprises a signaling device to produce an electrical signal, and that the electrical signal is no longer produced above a designated voltage of the DC voltage source (7).

8. Device according to at least one of the previous claims, **characterized in that** the changeover switch (15) is designed to activate the bypass link (14) when in its normal position.

9. Device according to at least one of the previous claims, **characterized in that** the monitoring device (8) has a timer circuit (12), and that the timer circuit (12) activates the bypass link (14) above a designated time period after activation of the DC/DC converter (13).

10. Device according to at least one of the previous claims, **characterized in that** the designated time period of the timer circuit (12) equals 20 to 180 seconds.

## Revendications

1. Système destiné à alimenter en courant électrique une pompe à carburant d'un moteur à combustion interne de véhicule automobile, comportant un premier branchement à raccorder à une source de tension continue et un deuxième branchement à raccorder à la pompe à carburant, **caractérisé par le fait que**, entre les branchements (4, 5), est placé un convertisseur à courant continu (13), lequel est conçu pour élever la tension continue de la source de tension continue (7) d'une tension continue faible inférieure à la tension de seuil existant au premier branchement (4) à une tension de service plus élevée prévue au deuxième branchement (5), que le convertisseur à courant continu (13) est connecté en parallèle avec un pontage (14), qui, dans le cas où la tension de la source de tension continue est suffisante, relie directement l'un à l'autre les deux branchements (4, 5) et qu'il est prévu un commutateur de sélection (15) permettant de sélectionner au choix soit le convertisseur à courant continu (13), soit le pontage (14).

2. Système selon la revendication 1, **caractérisé par le fait qu'**un dispositif de veille (8) destiné à surveiller la tension de la source de tension continue (7) est raccordé au premier branchement (4).

3. Système selon la revendication 1 ou 2, **caractérisé par le fait que** le dispositif de veille (8) comporte un détecteur de tension (9) avec un circuit de watchdog (10) destiné à surveiller la fonction du détecteur de tension (9).

4. Système selon au moins l'une des revendications précédentes, **caractérisé par le fait que** le commutateur de sélection (15) est monté sur le premier branchement (4) et est raccordé avec le pontage (14) et avec le convertisseur à courant continu (13).

5. Système selon au moins l'une des revendications précédentes, **caractérisé par le fait que** le commutateur de sélection (15) peut être commandé par le dispositif de veille (8).

6. Système selon au moins l'une des revendications précédentes, **caractérisé par le fait que** la commande du commutateur de sélection (15) au moyen du dispositif de veille (8) comporte un circuit à transistors ou un relais (11).

7. Système selon au moins l'une des revendications précédentes, **caractérisé par le fait que** le dispositif de veille (8) comporte un générateur de signaux destiné à produire un signal électrique et que le signal électrique est absent lorsque la tension de la source de tension continue (7) est supérieure à une tension prévue.

8. Système selon au moins l'une des revendications précédentes, **caractérisé par le fait que**, dans la position de repos, le commutateur de sélection (15) est conçu pour sélectionner le pontage (14).

9. Système selon au moins l'une des revendications précédentes, **caractérisé par le fait que** le dispositif de veille (8) a un circuit de temporisation (12) et que, après l'écoulement d'une période de temps donnée après l'activation du convertisseur à courant continu (13), le circuit de temporisation (12) active le pontage (14).

10. Système selon au moins l'une des revendications précédentes, **caractérisé par le fait que** la période de temps donnée du circuit de temporisation (12) se situe entre 20 et 180 secondes.
